# EUROPEAN PATENT SPECIFICATION

(11) **EP 4 605 706 B1**
(45) Date of publication and mention of the grant of the patent: **19.08.2026**
(21) Application number: 23800959.1
(22) Date of filing: 17.10.2023
(51) Int. Cl.: G01B 21/04, G01B 5/004

(54) **SENSOR FOR DETECTING A POSITION OF A MECHANICAL COMPONENT WITHIN A POLAR SPHERICAL COORDINATE REFERENCE SYSTEM**
SENSOR ZUR ERFASSUNG EINER POSITION EINER MECHANISCHEN KOMPONENTE IN EINEM POLAREN SPHÄRISCHEN KOORDINATENREFERENZSYSTEM
CAPTEUR DE DÉTECTION DE POSITION D'UN COMPOSANT MÉCANIQUE DANS UN SYSTÈME DE RÉFÉRENCE À COORDONNÉES SPHÉRIQUES POLAIRES

(30) Priority: 20.10.2022 IT 202200021657
(43) Date of publication of application: 27.08.2025
(73) Proprietor: Gefran S.p.A., 25050 Provaglio d'Iseo (Brescia) (IT)
(72) Inventor: ALGHISI, Davide, 25050 Provaglio d'Iseo, BRESCIA (IT); VACCARO, Michele, 25050 Provaglio d'Iseo, BRESCIA (IT); SVARA, Marco, 25050 Provaglio d'Iseo, BRESCIA (IT)
(74) Representative: Mozzi, Matteo
(86) International application number: PCT/IB2023/060466
(87) International publication number: WO 2024/084387

(56) References cited:
- DE-A1- 102017 131 102
- PL-B1- 207 418
- US-A1- 2011 078 914
- US-A1- 2019 072 373

## Description

### . Field of the invention

**.** The present invention relates to sensors employable for detecting movement between mechanical components, in particular to a sensor for detecting a position of a mechanical component within a polar spherical coordinate reference system.

### . Technological background of the invention

**.** Detecting the movement between mechanical components, such as the mechanical components of an articulated arm of an excavator, is a very important aspect of automation which allows accurately monitoring the reliability of such a movement during the service life of the mechanical components and therefore being able to intervene with maintenance and/or replacement activities in order to ensure an adequate performance as well as safety level.

**.** Nowadays, such a detection is obtainable with the employment of linear, self-supporting position sensors with a cylindrical body, which are widespread in the world of automation.

**.** They generally consist of a single-stage telescopic structure formed by a movable slider which slides with respect to a body of the sensor, which represents a fixed part.

**.** The free end of the movable slider is connected to a mechanical component the position of which is to be monitored, while the free end of the sensor body represents the origin of the measurement reference system.

**.** The position measurement produced by such a linear sensor is a function of the linear distance between the slider and the body of the sensor.

**.** Indeed, the movement of the mechanical component generates an extension or compression of the telescopic structure, with a consequent variation in distance between movable slider and sensor body.

**.** An apparent limitation of the aforesaid linear position sensor is that it is capable of producing only the linear position measurement because it transduces the cylindrical body which can extend and compress in a single direction in space.

**.** In order to overcome such a limitation, a mechanical component could be equipped with multiple linear position sensors which could ensure, as a whole, sturdiness, reliability and accuracy of the measurements produced.

**.** However, a solution based on multiple independent sensors located on the same mechanical component would be bulky, costly, complex and not always implementable from a practical viewpoint.
PL 207418 B1 discloses an appliance for measuring accuracy of the numerically controlled machines.

### . Summary

**.** It is the object of the present invention to devise and provide a sensor for detecting a position of a mechanical component within a polar spherical coordinate reference system which allows at least partially overcoming the drawbacks mentioned above with reference to the prior art and which is small in size, affordably manufacturable, and greatly versatile as for the possible implementations for which it could be intended.

**.** Such an object is achieved by a sensor according to claim 1.

**.** The present invention relates to a method for detecting a position of a mechanical component within a polar spherical coordinate reference system.

### . Brief description of the drawings

**.** Further features and advantages of the sensor according to the invention will become apparent from the following description of preferred embodiments thereof, given by way of non-limiting indication, with reference to the accompanying drawings, in which:
- Figure 1 diagrammatically shows a sensor for detecting a position of a mechanical component within a polar spherical coordinate reference system according to an embodiment of the present invention;
- Figure 2 diagrammatically shows, by means of a block diagram, a sensor for detecting a position of a mechanical component within a polar spherical coordinate reference system according to the present invention;
- Figure 3 shows a longitudinal section view of the sensor in Figure 1 for the purpose of illustrating the detection principle of a first linear position coordinate in a polar spherical coordinate reference system;
- Figures 4a and 4b show the side views of the sensor in Figure 1 for the purpose of illustrating the detection principle of a second colatitude coordinate in a polar spherical coordinate reference system;
- Figures 5a and 5b show top views of the sensor in Figure 1 for the purpose of illustrating the detection principle of a third longitude coordinate in a polar spherical coordinate reference system;
- Figures 6a and 6b show an example of use of the sensor in Figure 1;
- Figures 7a-7f show further examples of use of the sensor in Figure 1;
- Figure 8 diagrammatically shows a path travelled by a point of a mechanical component in a polar spherical coordinate reference system;
- Figure 9 diagrammatically shows a sensor for detecting a position of a mechanical component within a polar spherical coordinate reference system according to a further embodiment of the present invention;
- Figures 10, 11a, 11b and 12 show, by means of respective block diagrams, components of the sensor of the present invention, when employed to perform an action recognition method.

### . Detailed description

**.** With reference to the aforesaid drawings, a sensor 1 for detecting a position of a mechanical component within a polar spherical coordinate reference system S1 is now described.

**.** "Mechanical component" means any mechanical component employed in the industrial field the position of which requires to be measured and monitored during the movement thereof, for example, in the movable hydraulic field, a segment of an articulated arm of a material-handling machine, components of suspensions or power steering, components of agricultural means and tracked earthmoving machines, components of plastic molding machines, components of mold support carriages, extractors or rollers.

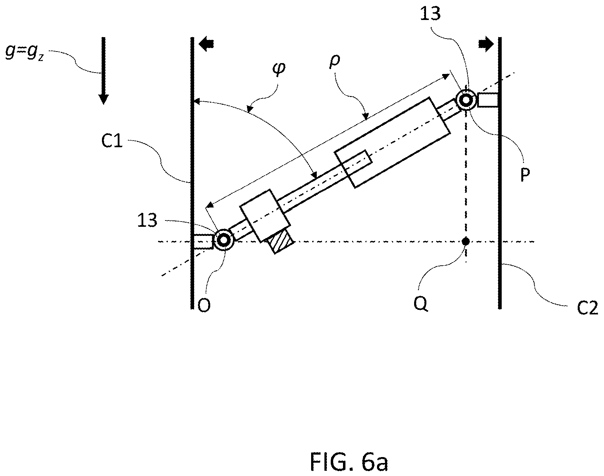

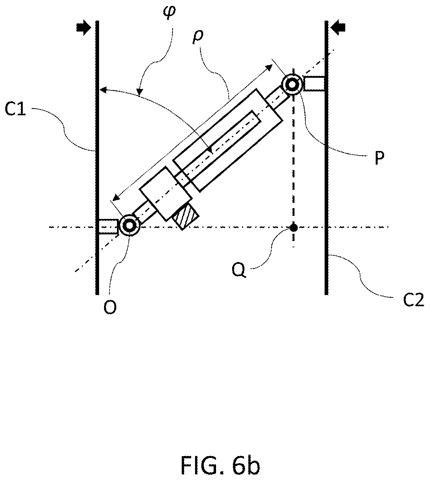

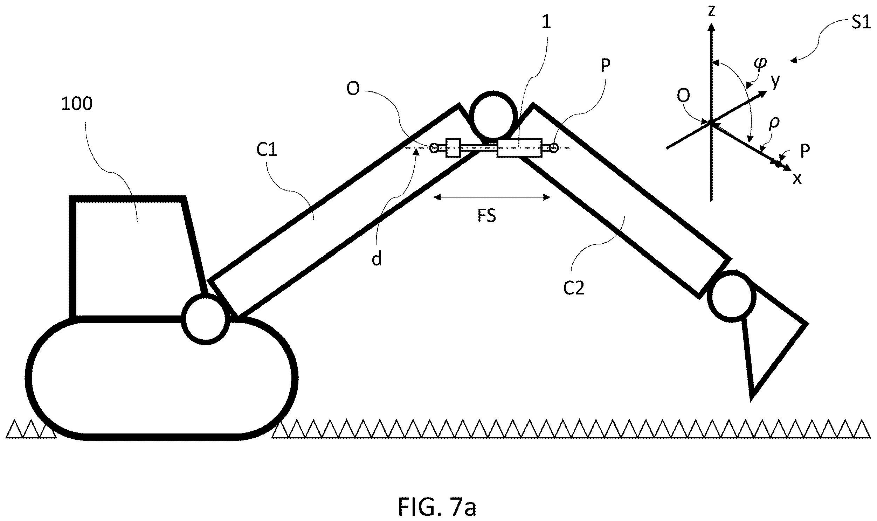

**.** By way of example, the mechanical component in Figures 6a and 6b is a wall (C1 or C2), while the mechanical component in Figures 7a-7f is a segment (C1 or C2) of an articulated excavator arm.

**.** Returning in general to the sensor 1 according to the present invention, it comprises a sensor body 4 extending along a longitudinal development axis d, the latter shown in the drawings with a dashed line.

**.** The sensor body 4 has a respective free end O configured to be operatively connected to a first mechanical component C1 (shown in Figures 6a, 6b, 7a-7f, for example).

**.** The free end O of the sensor body 4 represents the origin of a polar spherical coordinate reference system S1.

**.** The sensor 1 comprises a slider 2 operatively connected to the sensor body 4 so as to be able to slide, with respect to the sensor body 4, coaxially along the longitudinal development axis d of the sensor body 4.

**.** The slider 2 has a respective free end P configured to be operatively connected to a second mechanical component C2 (it also shown, for example, in Figures 6a, 6b, 7a-7f).

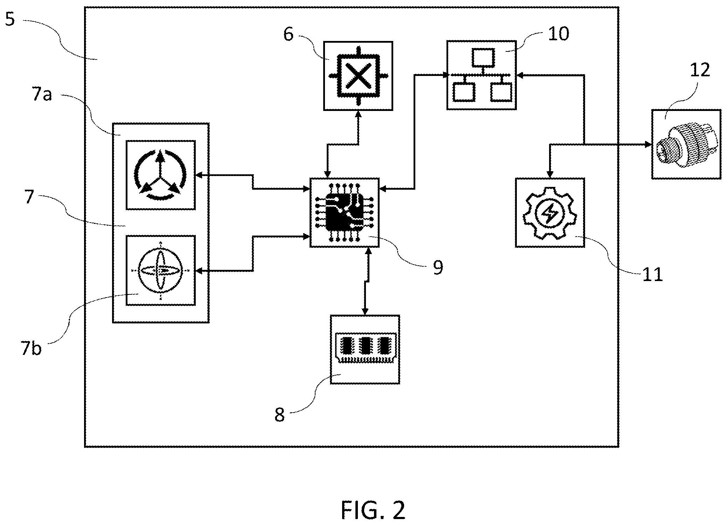

**.** With particular reference to Figure 2, the sensor 1 further comprises a data processing unit 9 accommodated inside the sensor body 4.

**.** The data processing unit 9 is, for example, a microcontroller, a microprocessor or a programmable logic device such as an FPGA (Field Programmable Gate Array).

**.** Moreover, the sensor 1 comprises a memory unit 8 operatively associated with the data processing unit 9.

**.** The memory unit 8 is accommodated inside the sensor body 4.

**.** The memory unit 8 is a rewritable and permanent type of memory and is based on EEPROM, FRAM or MRAM technology, for example.

**.** In greater detail, as diagrammatically shown in Figure 2, it should be noted that the data processing unit 9 and the memory unit 8 are preferably mounted on an electronic board 5 (diagrammatically shown in the drawings, where seen) accommodated inside the sensor body 4.

**.** The sensor 1 further comprises a linear position sensor 6, 3 accommodated inside the sensor body 4 and operatively connected to the data processing unit 9.

**.** The linear position sensor 6, 3 is configured to detect a first linear coordinate position p of a position of the free end P of the slider 2 in the polar spherical coordinate reference system S1.

**.** The sensor 1 further comprises an acceleration sensor 7, 7a accommodated inside the sensor body 4 and operatively connected to the data processing unit 9.

**.** The data processing unit 9 is configured to determine a second colatitude coordinate φ of the position of the free end P of the slider 2 in the polar spherical coordinate reference system S1 based on acceleration values to which the sensor body 4 is subject, which are detectable by the acceleration sensor 7, 7a.

**.** In greater detail, as diagrammatically shown in Figure 2, it should be noted that the acceleration sensor 7, 7a is also preferably mounted on the electronic board 5 accommodated inside the sensor body 4.

**.** The sensor 1 further comprises an angular speed sensor 7, 7b accommodated inside the sensor body 4 and operatively connected to the data processing unit 9.

**.** The data processing unit 9 is configured to determine a third longitude coordinate ϑ of the position of the free end P of the slider 2 in the polar spherical coordinate reference system S1 based on angular speed values to which the sensor body 4 is subject, which are detectable by the angular speed sensor 7, 7b.

**.** In greater detail, as diagrammatically shown in Figure 2, it should be noted that the angular speed sensor 7, 7b is also preferably mounted on the electronic board 5 accommodated inside the sensor body 4.

**.** According to the present invention, the data processing unit 9 is configured to store, in the memory unit 8, a plurality of sets of three detected polar spherical coordinates.

**.** Each set of three polar spherical coordinates comprises the first linear coordinate p, the second colatitude coordinate φ and the third longitude coordinate ϑ of the position of the free end P of the slider 2 in the polar spherical coordinate reference system S1 detected in an instant of time tᵢ, with 1 < i < N of a plurality of successive instants of time t₁, t₂, ..., tᵢ, ... t_{N}.

**.** The plurality of sets of three stored in the memory unit is representative of a path PS travelled by the free end P of the slider 2 in the polar spherical coordinate reference system S1.

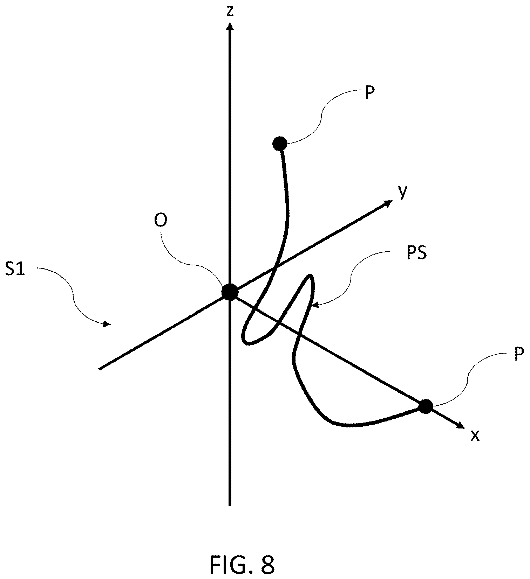

**.** An example of path PS is diagrammatically shown in Figure 8.

**.** According to an embodiment shown in the drawings, the linear position sensor 6, 3 comprises a sensible element 6 arranged on the sensor body 4 and an electric or magnetic element 3 arranged on the slider 2.

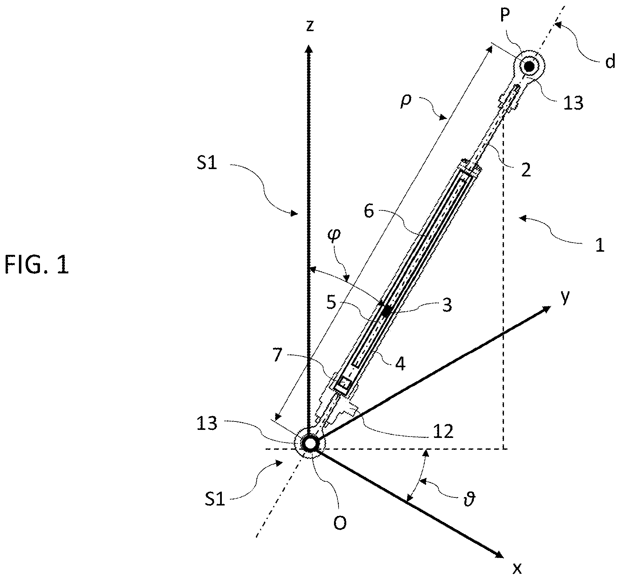

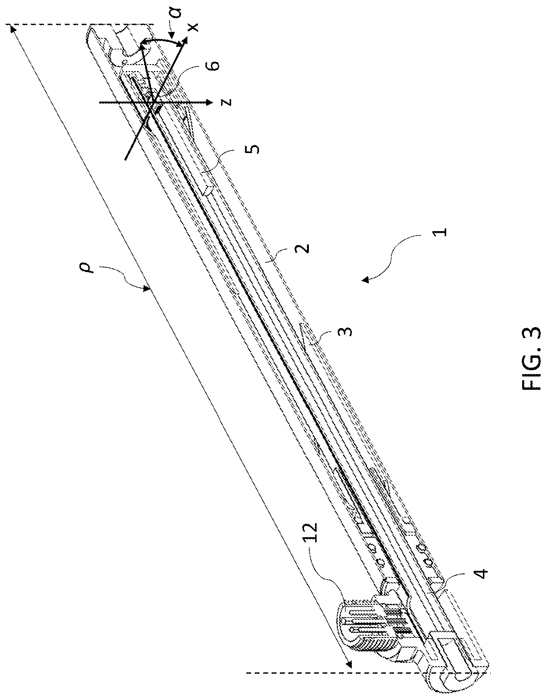

**.** According to an embodiment, in combination with the preceding one and shown in Figures 1 and 3, the sensible element 6 is a resistive track extending along the sensor body 4 along the longitudinal development axis d and the electric or magnetic element 3 is at least one sliding contact.

**.** In this embodiment, the first linear coordinate p of the position of the free end P of the slider 2 in the polar spherical coordinate reference system S1, i.e., the mutual position of the slider 2 with respect to the sensor body 4 (carrier radius) is a function of a resistive value of the resistive track measurable between an end of the resistive track and the position of the at least one sliding contact on the resistive track.

**.** It should be noted that in this embodiment, the principle applied by the linear position sensor 6, 3 for detecting the first linear coordinate p of the position of the free end P of the slider 2 in the polar spherical coordinate reference system S1 is a potentiometric-type principle.

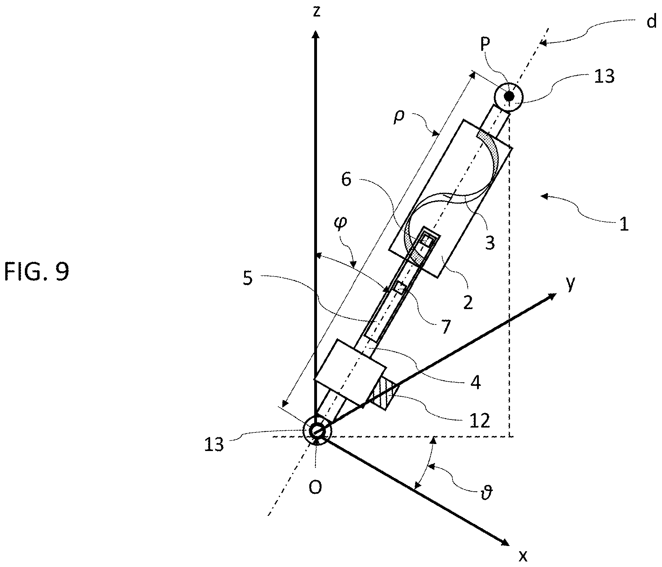

**.** According to a further embodiment, alternative to the preceding one and shown in Figure 9, the sensible element 6 is a magnetic field sensor arranged in the sensor body 4 so that respective mutually orthogonal sensible axes are in turn orthogonal to the longitudinal development axis d.

**.** In this embodiment, the electric or magnetic element 3 is a cylindrical magnetic helix wound around the slider 2 along the longitudinal development axis d.

**.** In this embodiment, the first linear coordinate of the position of the free end P of the slider 2 in the polar spherical coordinate reference system S1 is a function of a magnetic field orientation generatable by the cylindrical magnetic helix according to a cylindrical helix development.

**.** In greater detail, the magnetic field sensor is preferably arranged on the electronic board 5 accommodated inside the sensor body 4 so as to have the respective mutually orthogonal sensible axes, which in turn are orthogonal to the longitudinal development axis d, so as to be able to measure an angular orientation α of the magnetic field generated by the cylindrical magnetic helix.

**.** The angular orientation measurement α detected by the magnetic field sensor varies at most in the range of values 0° - 360°, with the extreme of the range not included because coincident with value 0°.

**.** Therefore, the magnetic field sensor represents a detection sensor of absolute angular orientation on a single revolution.

**.** By way of example, assuming that:
- the cylindrical magnetic helix has a constant pitch;
- the measurement α is detected and provided by the magnetic field sensor in an increasing manner with respect to the extension of the slider 2 with respect to the sensor body 4;
- at a resting position ρ₀ of the sensor 1 (completely compressed), the magnetic field sensor provides an angular orientation value α ≈ 0°;
- at a bottom-scale position FS of the sensor 1 (completely extracted), the magnetic field sensor provides an angular orientation value α ≈ 360°;
- the free end O of the sensor body 4, connected to a first mechanical component C1, represents the origin of the polar spherical coordinate reference system S1,
- the free end P of the slider 2 is connected to a second mechanical component C2;
it is possible to relate the mutual position of the slider 2 with respect to the sensor body 4, i.e. the first linear coordinate p of the position of the free end P of the slider 2 in the polar spherical coordinate reference system S1, also referred to as carrier radius, with the measurement of the angular orientation value α of the magnetic field generated by the cylindrical magnetic helix according to the development of a cylindrical helix, as indicated by the following mathematical relationship: $ρ = \frac{α}{360} ⋅ FS + {ρ}_{0}$

**.** According to further embodiments, the sensible element 6 is a magnetic field sensor made from a Hall effect integrated circuit, or giant magnetoresistive or tunnel.

**.** According to further embodiments, the sensible element 6 of the linear position sensor 6, 3 can be a wire of magnetostrictive material and the electric or magnetic element 3 of the linear position sensor 6, 3 can be a magnet.

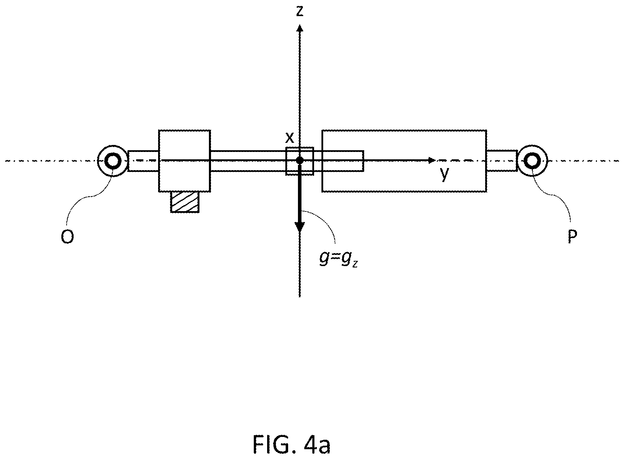

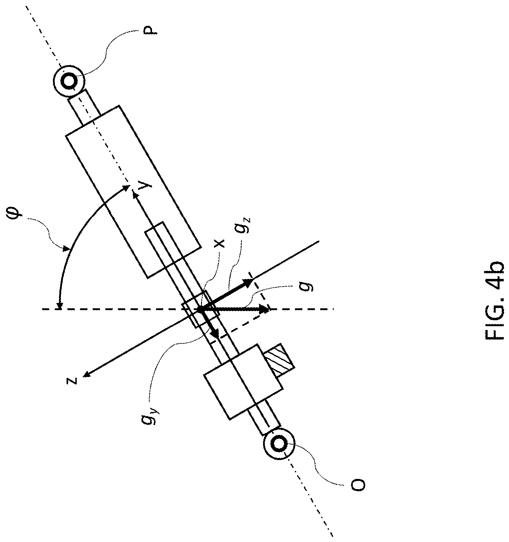

**.** According to an embodiment, in combination with any one of those described above, shown in Figures 2, 4a and 4b, the acceleration sensor 7, 7a comprises at least one accelerometer 7a with a respective set of three mutually orthogonal sensible axes x, y, z (shown in Figures 4a and 4b).

**.** The at least one accelerometer 7b is in MEMS technology, for example.

**.** The second colatitude coordinate φ of the position of the free end P of the slider 2 in the polar spherical coordinate reference system S1 is a function of acceleration values to which the sensor body 4 is subject, which are detectable by the at least one accelerometer 7a along each of the sensible axes x, y, z of the respective set of three sensible axes.

**.** With particular reference to Figures 4a and 4b, the second colatitude coordinate φ of the position of the free end P of the slider 2 in the polar spherical coordinate reference system S1 is represented by the inclination of the plane on which the sensible axes x and y of the set of three sensible axes of the at least one accelerometer 7a lie with respect to the gravity acceleration direction g.

**.** For example, in this embodiment, the second colatitude coordinate φ can be, for example, calculated with the following mathematical relationship: $φ = atan \left(\frac{\sqrt{{g}_{x}^{2} + {g}_{z}^{2}}}{{g}_{y}}\right)$
**.** where:
**.** gₓ is the projection of the gravity acceleration g along the sensible axis x of the at least one accelerometer 7a;
**.** g_{y} is the projection of the gravity acceleration g along the sensible axis y of the at least one accelerometer 7a;
**.** g_{z} is the projection of the gravity acceleration g along the sensible axis z of the at least one accelerometer 7a.

**.** According to a further embodiment, in combination with the preceding one, the angular speed sensor 7, 7b comprises at least one gyroscope 7b with a respective set of three mutually orthogonal sensible axes x, y, z.

**.** The data processing unit 9 is configured to determine the second colatitude coordinate φ of the position of the free end P of the slider 2 in the polar spherical coordinate reference system S1 as a function of acceleration values to which the sensor body 4 is subject, which are detectable by the at least one accelerometer 7a along each of the sensible axes x, y, z of the respective set of three sensible axes and angular speed values detectable by the at least one gyroscope 7b along each of the sensible axes x, y, z of the respective set of three sensible axes.

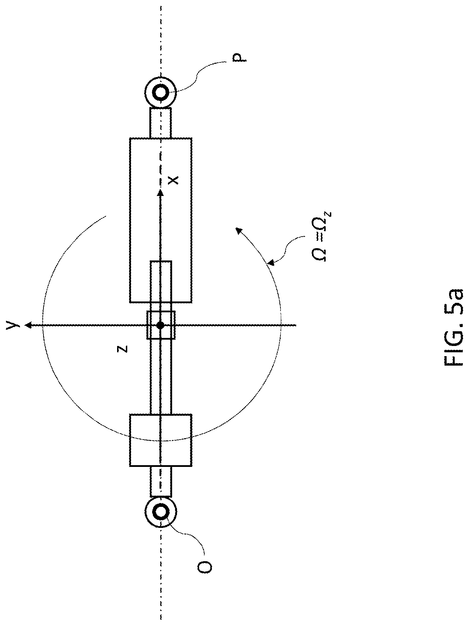

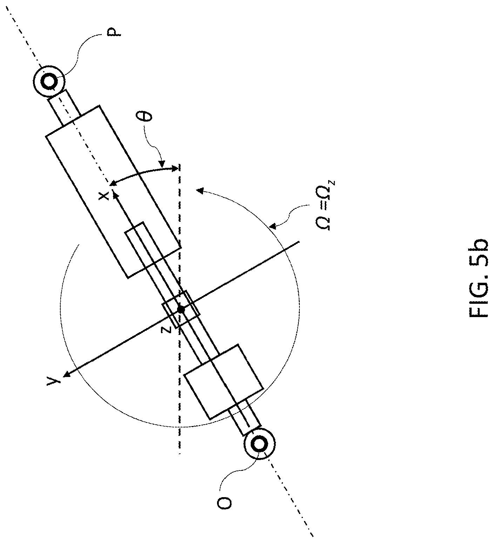

**.** According to a further embodiment, in combination with any one of the preceding ones, shown in Figures 2, 5a and 5b, the angular speed sensor 7, 7b comprises at least one gyroscope 7b with a respective set of three mutually orthogonal sensible axes x, y, z.

**.** The data processing unit 9 is configured to determine the third longitude coordinate ϑ of the position of the free end P of the slider 2 in the polar spherical coordinate reference system S1 as a function of angular speed values to which the sensor body 4 is subject, which are detectable by the at least one gyroscope 7b along each of the sensible axes of the respective set of three sensible axes, and of an initial inclination value of the longitudinal development axis d with respect to the set of three sensible axes of the at least one gyroscope 7b.

**.** In particular, the inclination of the longitudinal development axis d with respect to the initial inclination value θ₀, with respect to the set of three sensible axes of the at least one gyroscope 7b, occurs on a plane on which the sensible axes x, y of the set of three sensible axes x, y, z of the at least one gyroscope 7b lie.

**.** The third longitude coordinate ϑ of the position of the free end P of the slider 2 in the polar spherical coordinate reference system S1 can be, for example, calculated by means of an integration in time of the angular speed Ω to which the sensor body 4 is subject with respect to an initial inclination value ϑ₀, employing the following mathematical relationship: $ϑ = \int Ω ⋅ dt + {ϑ}_{0}$
**.** in which the angular speed Ω is determined by the data processing unit 9 as a combination of the components Ωₓ, Ω_{y} and Ω_{z} thereof, i.e., the projections of the angular speed Ω along the respective sensible axes x, y, z of the set of three sensible axes of the at least one gyroscope 7.

**.** According to an embodiment, in combination with any one of the preceding ones and shown in the drawings, the respective free end O of the sensor body 4 comprises a self-aligning joint.

**.** According to an embodiment, in combination with any one of the preceding ones and shown in the drawings, the respective free end P of the slider 2 comprises a self-aligning joint.

**.** According to an embodiment, in combination with any one of those described above, shown in Figure 2, the sensor 1 further comprises a bus communication module 10 operatively connected to the data processing unit 9 which allows the exchange of electrical signals between the data processing unit 9 and the field bus used in the control system of the mechanical components to which the sensor 1 is connected.

**.** According to an embodiment, in combination with the preceding one, shown in the drawings, the sensor 1 further comprises a connector 12 adapted to provide the electrical connection (electrical supply voltage and electrical signals) to the field bus used in the control system of the mechanical components to which the sensor 1 is connected.

**.** The connector 12 is also operatively connected to the data processing unit 9 by means of the bus communication module 10.

**.** In an embodiment, in combination with the preceding one, shown in Figure 2, the sensor 1 further comprises an electrical supply management module 11 operatively connected to the connector 12, adapted to generate the levels of electrical voltage required for the operation of the electronic devices accommodated inside the sensor body 4 starting from the electrical supply voltage supplied to the field bus.

**.** Also referring now to Figures 6a and 6b, the first mechanical component C1 comprises a first surface and the second mechanical component C2 comprises a second surface.

**.** The first surface and the second surface face each other.

**.** In an embodiment, in combination with any one of those described above, the data processing unit 9 is configured to determine a real distance OP between the first surface and the second surface based on the first linear coordinate ρ and the second colatitude coordinate φ of the position of the free end P of the slider 2 in the polar spherical coordinate reference system S1 belonging to a detected set of three polar spherical coordinates.

**.** For example, the real distance OP between the first surface and the second surface is determinable, by the data processing unit 9, by employing the following mathematical relationship: $\overline{OP} = ρ ⋅ sin \left(φ\right)$

**.** Moreover, according to an embodiment, in combination with the preceding one, the data processing unit 9 is configured to determine a misalignment between the free end P of the slider and the free end O of the sensor body 4 based on the first linear coordinate p and the second colatitude coordinate φ of the position of the free end P of the slider 2 in the polar spherical coordinate reference system S1 belonging to a detected set of three polar spherical coordinates.

**.** The determination of a misalignment advantageously allows obtaining an indication on the sensor 1 being properly or not properly installed between the first surface and the second surface.

**.** For example, a misalignment between the free end P of the slider and the free end O of the sensor body 4 is determinable, by the data processing unit 9, by means of employing the following mathematical relationship: $\overline{PO} = ρ ⋅ cos \left(φ\right)$

**.** Therefore, the misalignment error made during the installation of the sensor 1 is of non-linear type, increasing with the cosine of the second colatitude coordinate φ.

**.** According to an embodiment, according to any one of those described above, the path PS travelled by the free end P of the slider 2 in the polar spherical coordinate reference system S1 represented by a plurality of sets of three stored in the memory unit 8 is representative of a set action carried out by the first mechanical component C1 and the second mechanical component C2 and employable as reference recognition model in a recognition algorithm of movement models.

**.** Indeed, the recognition of actions carried out by mechanical components can be carried out with different methods, including the use of raw data in the set of three polar spherical coordinates ρ, φ and ϑ measured in an set time instant tᵢ, 1 < i < N, N being integer, as input, and the extraction of different features which can be used as input for the implementable recognition method.

**.** By analyzing the evolution of the individual sets of three polar spherical coordinates produced by the sensor 1 of the present invention, indeed it is possible to identify unique combinations which describe the performance of a particular action carried out by mechanical components.

**.** With reference to Figures 7a-7f, reference is made below to an articulated arm C1, C2 of an excavator 100.

**.** For example, assuming that the articulated arm of the excavator shown in Figure 7a is in the initial condition thereof in plane XZ of the polar spherical coordinate reference system S1, an action of extending the articulated arm C1, C2 is uniquely defined when:
- the first linear coordinate ρ is close to the maximum extension FS;
- the second colatitude coordinate φ is almost orthogonal to the horizontal (for the frequency of the function *atan =* 90°);
- the third longitude coordinate ϑ is equal to zero because it is assumed that the initial condition is of movement in the plane XZ of the polar spherical coordinate reference system S1.

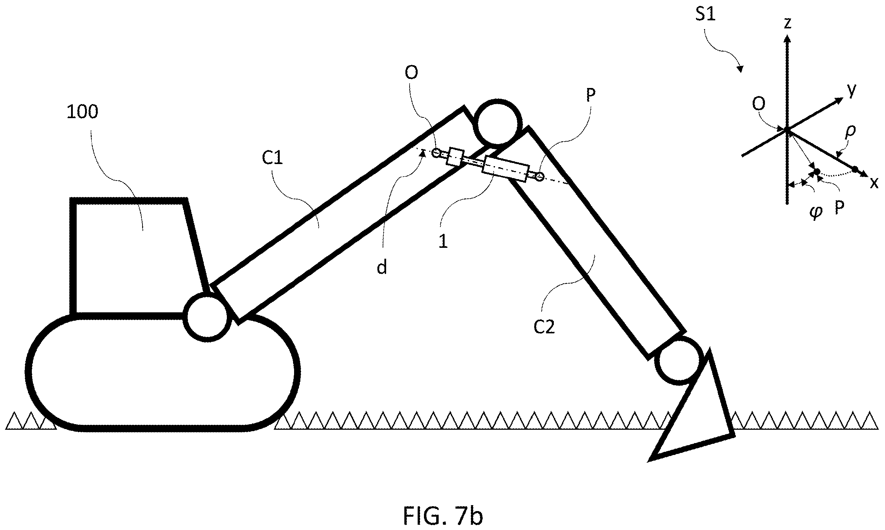

**.** A bucket standing action in the material loading area shown in Figure 7b is uniquely defined when:
- the first linear coordinate ρ has decreasing trend;
- the second colatitude coordinate φ has exceeded a discontinuity of periodicity of the function *atan* and has increasing negative value;
- the third longitude coordinate ϑ is equal to zero because it is assumed that the initial condition is of movement in the plane XZ of the polar spherical coordinate reference system S1.

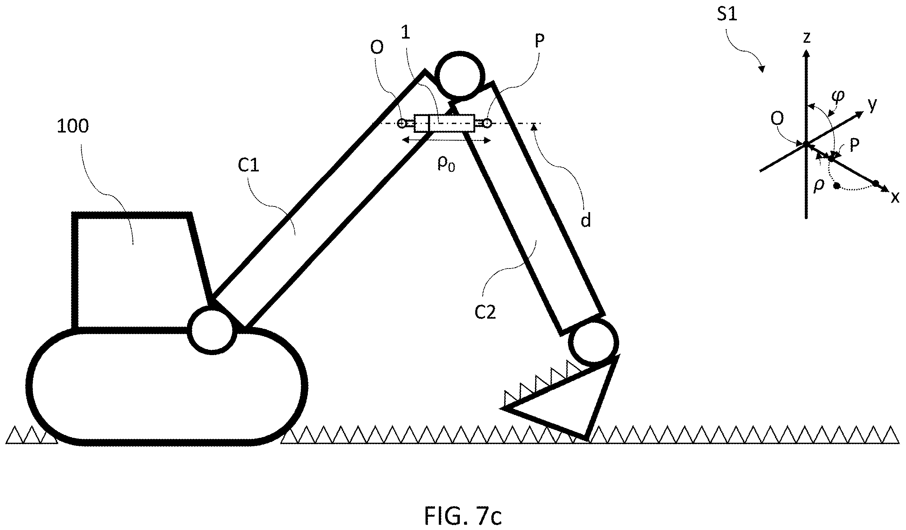

**.** A material loading action shown in Figure 7c is uniquely defined when:
- the first linear coordinate ρ is close to the minimum extension ρ₀;
- the second colatitude coordinate φ has become horizontal again, around the point of discontinuity +/-90°;
- the third longitude coordinate ϑ is equal to zero because it is assumed that the initial condition is of movement in the plane XZ of the polar spherical coordinate reference system S1.

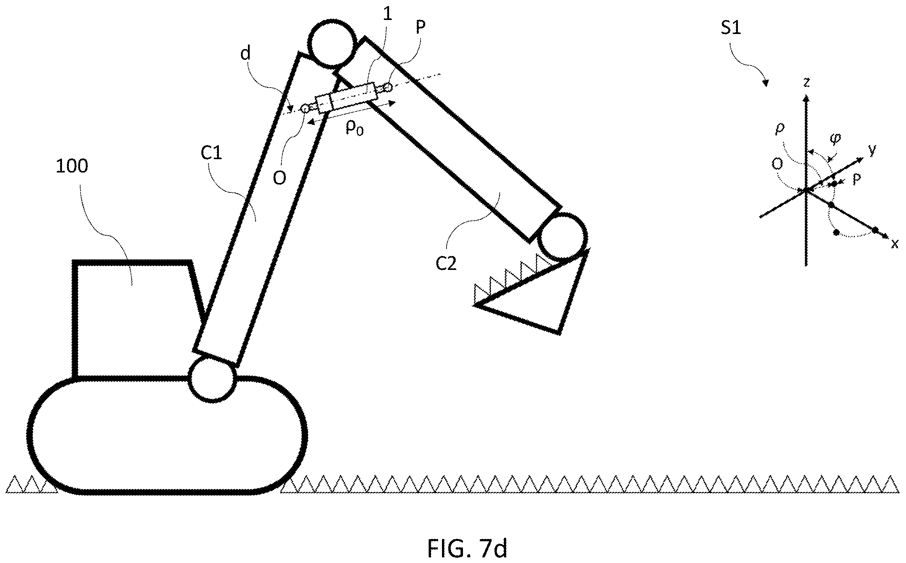

**.** A loading bucket raising action shown in Figure 7d is uniquely defined when:
- the first linear coordinate ρ is close to the minimum extension ρ₀;
- the second colatitude coordinate φ has exceeded a discontinuity of periodicity of the function *atan* and has decreasing positive value;
- the third longitude coordinate ϑ is equal to zero because it is assumed that the initial condition is of movement in the plane XZ of the polar spherical coordinate reference system S1.

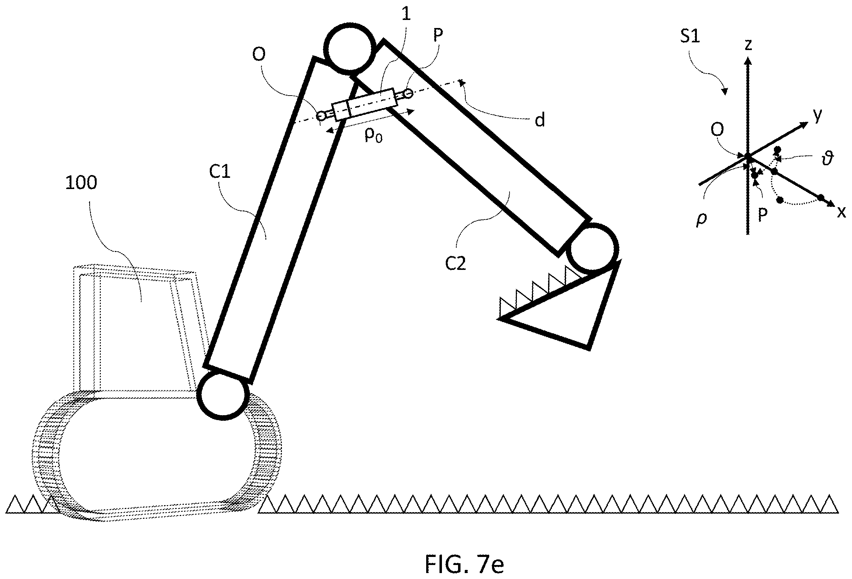

**.** A rotation action towards the material unloading area shown in Figure 7e is uniquely defined when:
- the first linear coordinate ρ is close to the minimum extension ρ₀;
- the second colatitude coordinate φ has exceeded a discontinuity of periodicity of the function *atan* and has decreasing positive value;
- the third longitude coordinate ϑ has increasing positive value.

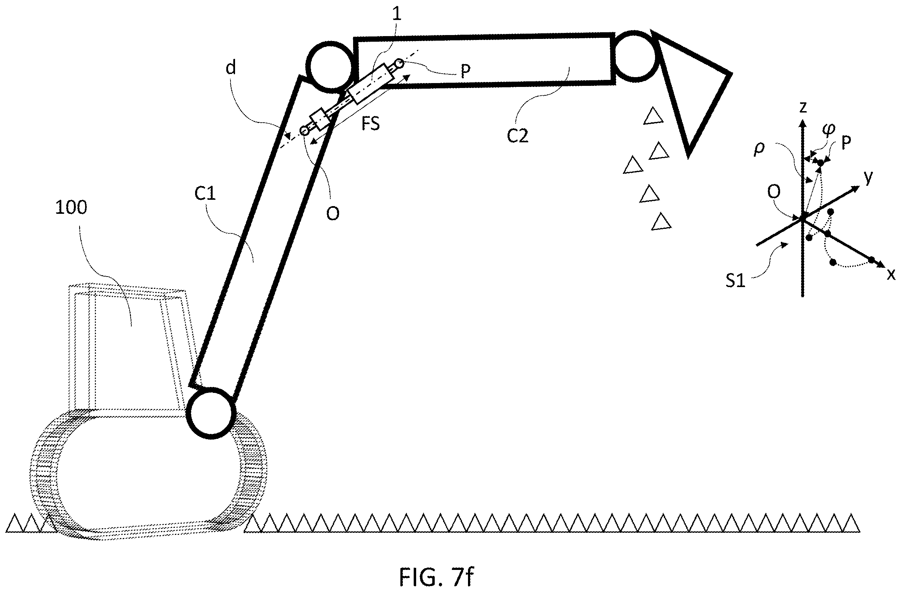

**.** A material unloading action shown in Figure 7f is uniquely defined when:
- the first linear coordinate ρ is close to the maximum extension FS;
- the second colatitude coordinate φ has exceeded a discontinuity of periodicity of the function *atan* and has decreasing positive value;
- the third longitude coordinate ϑ has increasing positive value.

**.** Thus, the excavating activity is therefore formed by a sequence of actions, to which correspond specific movements that the measurer performs in space by tracing a characteristic path PS, an example of which is shown in Figure 8.

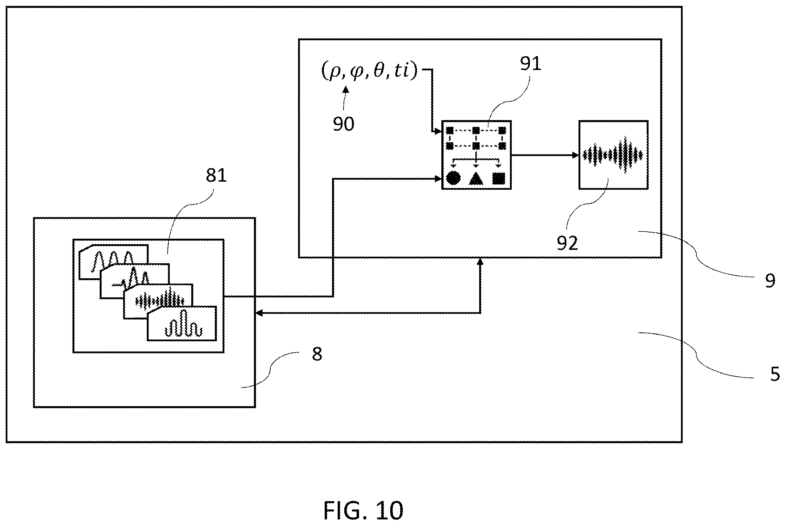

**.** According to the present invention, according to an embodiment shown in Figure 10, an action recognition method executable by the data processing unit 9 of the sensor 1 is now described.

**.** Such a method implements a movement model recognition concept (Motion Pattern Recognition), known per se.

**.** According to the method, the polar spherical coordinates ρ, φ and ϑ referring to instant tᵢ are input 90 provided to a recognition algorithm 91 which is capable of discriminating the corresponding action in that precise moment with an excellent degree of accuracy.

**.** The recognition algorithm 91 is, for example, a pattern matching algorithm or a neural network, for example, of the RNN (Recurrent Neural Network) type.

**.** Pattern matching is a form of model recognition in which the data are represented as series of carriers of features and/or parameters referred to as models, shown in Figure 10 by reference numeral 81.

**.** Each action (model 81) is stored in the memory unit 8 as a separate model.

**.** The inputs 90 are organized in models 81 stored before performing the recognition process.

**.** At the start of the recognition process, an input 90 is compared with the models 81 stored in the memory unit 8 (as shown in Figure 10).

**.** The stored model 81 corresponding the most to the model corresponding to the input 90 is identified as action and it is said selected model 92 which will be the best match for input 90.

**.** Model matching is performed at path level associated with the movement of the mechanical components.

**.** The matching process involves a frame-by-frame comparison of the spectral models and generates an overall similarity assessment for each model.

**.** It is not necessary for the comparison to produce an identical match to establish an overall similarity because the single actions, and therefore the movement of a same mechanical component, are affected by the surrounding environment.

**.** This variation can be due to a series of factors, among which the different speed with which the action is performed, or the different orientation of the axes of the reference system.

**.** Whatever the cause of the variation between the stored models 81 and the input 90, it is necessary for there to be a way for minimizing the time differences between the models so that the quickest or slowest actions of the same movement are not identified as different movements.

**.** In this respect, it is known in literature that the minimization process of the time differences is referred to as time alignment.

**.** The approach most commonly used for performing the time alignment in model matching is a pattern matching technique referred to as Dynamic Time Warping (DTW).

**.** Most model matching systems have a predetermined acceptability threshold.

**.** The function thereof is that of avoiding the noise and situations not included in the stored models 81 from being erroneously identified as acceptable inputs.

**.** If no model matching exceeds the acceptability threshold, no recognition is registered.

**.** Model matching is highly effective with short and distinct actions and it is necessary for there to be at least all the models capable of representing the almost totality of the actions.

**.** Alternatively to pattern matching algorithms, it is possible to use recurrent neural networks (RNN), which are a type of neural network specialized in the use of sequential data or time series.

**.** As all neural networks, recurrent neural networks also use training data to learn.

**.** They stand out for their "memory" because they take information from preceding inputs to affect the current input and output.

**.** In this respect, while traditional networks presume the inputs and outputs are independent from one another, the output of recurrent neural networks depends on the elements preceding the sequence.

**.** By way of example, it should be considered a sequence of a determined movement.

**.** For it to make sense, such a sequence must be expressed in a specific order.

**.** Consequently, recurrent neural networks must consider the form and use this information to predict the successive action in the sequence.

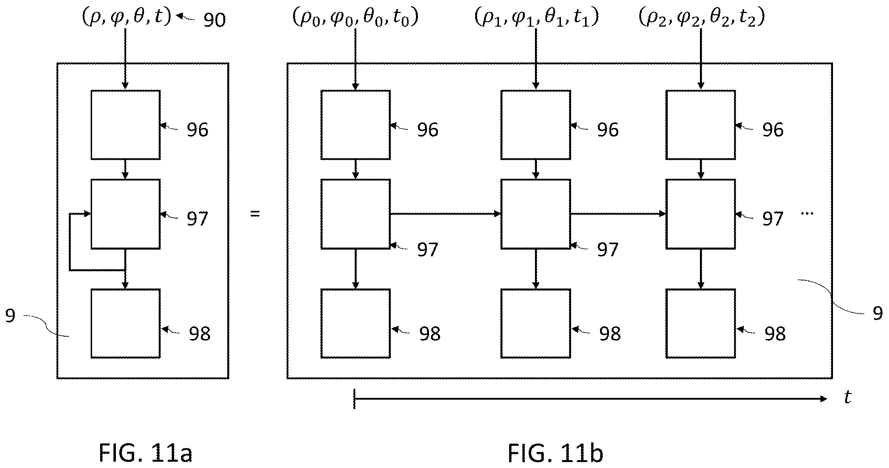

**.** With reference to the graph shown in Figure 11a, the rolled view of the recurrent neural network RNN, comprising nodes 96, 97 and 98, represents the entire neural network, which in the case of the proposed sensor, represents the entire predicted action for the mechanical component described by a determined sequence of input 90.

**.** The unrolled view, shown in Figure 11b, instead shows the single layers, or time phases, of the recurrent neural network.

**.** Each layer, comprising nodes 96, 97 and 98, corresponds to a single piece of information of the sequence in a given time instant tᵢ, therefore to the single variable ρ, ∘ φ ∘ ϑ.

**.** The inputs at the preceding time instants are shown as a hidden state in the third phase to predict the output of the action taking place or the successive sequence.

**.** Another distinctive feature of recurrent neural networks is the sharing of the parameters in each layer of the network.

**.** As with a pattern matching algorithm, a training path for creating a reference dataset is also provided for recurrent neural network RNN training.

**.** In this respect, the stored models 81 are learned by the sensor 1 during a dedicated training session.

**.** The learned models are registered in the memory unit 8 in the step referred to as enrollment and will constitute the reference dataset for a pattern matching algorithm.

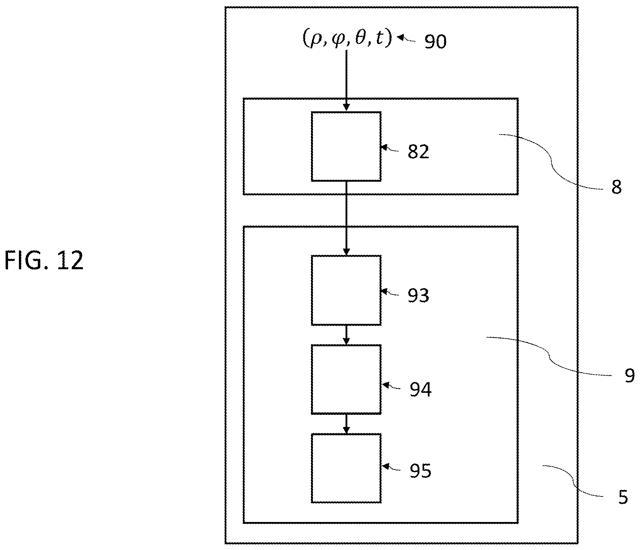

**.** A general architecture of the training step is shown in Figure 12.

**.** The analysis of the action performed autonomously by the data processing unit 9 of the sensor 1 also enables the identification of "how" the action is performed.

**.** In this case, the subject being studied is the identification of a particular faulty condition.

**.** In order to implement this functionality, it is sufficient to also enter, in the reference dataset of stored models 81, registrations related to the faulty conditions to be identified.

**.** Once identified, the data processing unit 9 of the sensor 1 can suggest maintenance activities based on prescribed interventions for each cause.

**.** A method of detecting a position of a mechanical component within a polar spherical coordinate reference system S1 is now described.

**.** The method comprises a step of providing a sensor body 4 extending along a longitudinal development axis d. The sensor body 4 has a respective free end O configured to be operatively connected to a first mechanical component. The free end O of the sensor body 4 represents the origin of the polar spherical coordinate reference system S1.

**.** The method further comprises step of providing a slider 2 operatively connected to the sensor body 4 so as to be able to slide, with respect to the sensor body 4, coaxially along the longitudinal development axis d of the sensor body 4. The slider 2 has a respective free end P configured to be operatively connected to a second mechanical component C2.

**.** The method further comprises a step of providing a data processing unit 9 accommodated inside the sensor body 4.

**.** The method further comprises a step of providing a memory unit 8 operatively associated with the data processing unit 9. The memory unit 8 is accommodated inside the sensor body 4.

**.** The method further comprises a step of providing a linear sensor 6, 3 accommodated inside the sensor body 4 and operatively connected to the data processing unit 9.

**.** The method further comprises a step of providing an acceleration sensor 7, 7a accommodated inside the sensor body 4 and operatively connected to the data processing unit 9.

**.** The method further comprises a step of providing an angular speed sensor 7, 7b accommodated inside the sensor body 4 and operatively connected to the data processing unit 9.

**.** The method, for each instant of time tᵢ, 1 < i < N, N being integer, of a plurality of successive instants of time t₁, t₂, ..., tᵢ, ..., t_{N}, comprises steps of:
- detecting, by said linear sensor 6, 3, a first linear coordinate p of a position of the free end P of the slider 2 in the polar spherical coordinate reference system S1;
- determining, by the data processing unit 9, a second colatitude coordinate φ of the position of the free end P of the slider 2 in the polar spherical coordinate reference system S1 based on acceleration values to which the sensor body 4 is subject, which are detected by the acceleration sensor 7, 7a;
- determining, by the data processing unit 9, a third longitude coordinate ϑ of the position of the free end P of the slider 2 in the polar spherical coordinate reference system S1 based on angular speed values to which the sensor body 4 is subject, which are detected by said angular speed sensor 7, 7b;
- storing, in the memory unit 8, by the data processing unit 9, a set of three polar spherical coordinates comprising the first linear coordinate p, the second colatitude coordinate φ and the third longitude coordinate ϑ of the position of the free end P.

**.** A plurality of sets of three polar spherical coordinates stored in the memory unit 8 is representative of a path PS travelled by the free end P of the slider 2 in the polar spherical coordinate reference system S1.

**.** As shown, the object of the present invention is fully achieved because the sensor just described has several advantages.

**.** The self-supporting position sensor of the present invention with cylindrical body, consisting of a movable slider, the end of which is connected to a first mechanical component, and a fixed sensor body, the free end of which represents the origin of the polar spherical coordinate reference system, can be defined as multivariable because it comprises multiple sensible elements adapted to measure both linear movements and the rotation and inclination with respect to the horizontal.

**.** A specific data processing unit included in the sensor body combines the linear movement, rotation and inclination measurements to determine the polar spherical coordinates identifying the position of the first mechanical component within the polar spherical coordinate reference system.

**.** The time evolution of the polar spherical coordinates is registered in a specific memory unit always included in the sensor body and represents a path travelled by the first mechanical component during the measuring.

**.** From a metrological viewpoint, the sensor is advantageously autonomous in compensating for any residual misalignments of the installation step which can compromise the accuracy of the position measurement.

**.** From a functional viewpoint, by analyzing the path travelled by the mechanical component being measured, the sensor is autonomous in recognizing the actions performed by the mechanical component, comparing them with stored models of actions learned previously in a training step.

**.** In addition, being in fact of the stand-alone type, the sensor of the present invention certainly improves the disadvantages of the background art concerning poor resolution, bulkiness, cost and complexity.

**.** Indeed, the sensor of the present invention is a contact sensor, self-supporting, has a cylindrical body and comprises therein the possibility of producing simultaneously and storing several types of position measurement (linear, angular, inclination).

**.** Moreover, the sensor of the present invention complies with the requirements of a position sensor, which are:
- maximum measurement range of the extension of an articulated arm of the order of a meter;
- low cost;
- sturdiness, to resist extreme temperatures from -40°C up to +85°C, thermal and mechanical shock up to 50 g, vibrations, corrosion and solar radiation;
- increased levels of reliability according to functional safety standards.

**.** In order to meet contingent needs, those skilled in the art may make changes and adaptations to the above-described embodiments of the sensor, and replace elements with others which are functionally equivalent, without departing from the scope of the following claims.

**.** Each of the features described above as belonging to one possible embodiment can be implemented irrespective of the other embodiments described.

## Claims

1. A sensor (1) for detecting a position of a mechanical component within a polar spherical coordinate reference system (S1), comprising:
- a sensor body (4) extending along a longitudinal development axis (d), said sensor body (4) having a respective free end (O) configured to be operatively connected to a first mechanical component (C1), the free end (O) of the sensor body (4) representing the origin of the polar spherical coordinate reference system (S1);
- a slider (2) operatively connected to the sensor body (4) so as to slide, with respect to the sensor body (4), coaxially along the longitudinal development axis (d) of the sensor body (4), said slider (2) having a respective free end (P) configured to be operatively connected to a second mechanical component (C2);
the sensor (1) further comprising:
- a data processing unit (9) accommodated inside the sensor body (4);
- a memory unit (8) operatively associated with the data processing unit (9), the memory unit (8) being accommodated inside the sensor body (4);
- a linear position sensor (6, 3) accommodated inside the sensor body (4) and operatively connected to the data processing unit (9), said linear sensor (6, 3) being configured to detect a first linear coordinate (ρ) of a position of the free end (P) of the slider (2) in the polar spherical coordinate reference system (S1); **characterised by**
- an acceleration sensor (7, 7a) accommodated inside the sensor body (4) and operatively connected to the data processing unit (9), the data processing unit (9) being configured to determine a second colatitude coordinate (φ) of the position of the free end (P) of the slider (2) in the polar spherical coordinate reference system (S1) based on acceleration values to which the sensor body (4) is subject, which are detectable by the acceleration sensor (7, 7a);
- an angular speed sensor (7, 7b) accommodated inside the sensor body (4) and operatively connected to the data processing unit (9), the data processing unit (9) being configured to determine a third longitude coordinate (ϑ) of the position of the free end (P) of the slider (2) in the polar spherical coordinate reference system (S1) based on angular speed values to which the sensor body (4) is subject, which are detectable by said angular speed sensor (7, 7b),
the data processing unit (9) being configured to store, in the memory unit (8), a plurality of sets of three detected polar spherical coordinates, each set of three polar spherical coordinates comprising the first linear coordinate, the second colatitude coordinate and the third longitude coordinate of the position of the free end (P) of the slider (2) in the polar spherical coordinate reference system (S1) detected in an instant of time tᵢ, 1 < i < N, N being integer, of a plurality of successive instants of time t₁, t₂, ..., tᵢ, ..., t_{N},
the plurality of sets of three stored in the memory unit (8) being representative of a path (PS) travelled by the free end (P) of the slider (2) in the polar spherical coordinate reference system (S1).

2. The sensor (1) according to claim 1, wherein the linear position sensor (6, 3) comprises a sensing element (6) arranged on the sensor body (4) and an electric or magnetic element (3) arranged on the slider (2).

3. The sensor (1) according to claim 2, wherein the sensing element (6) is a resistive track extending along the sensor body (4) along the longitudinal development axis (d) and the electric or magnetic element (3) is at least one sliding contact, the first linear coordinate (p) of the position of the free end (P) of the slider (2) in the polar spherical coordinate reference system (S1) being a function of a resistive value of the resistive track measurable between one end of the resistive track and the position of the at least one sliding contact on the resistive track.

4. The sensor (1) according to claim 2, wherein the sensing element (6) is a magnetic field sensor arranged in the sensor body (4) so that respective mutually orthogonal sensing axes in turn are orthogonal to the longitudinal development axis (d), and the electric or magnetic element (3) is a cylindrical magnetic helix wound around the slider (2) along the longitudinal development axis (d), the first linear coordinate (p) of the position of the free end (P) of the slider (2) in the polar spherical coordinate reference system (S1) being a function of a magnetic field orientation generatable by the cylindrical magnetic helix according to a cylindrical helix development.

5. The sensor (1) according to claim 4, wherein the sensing element (6) is a magnetic field sensor made from a Hall effect integrated circuit, or giant magnetoresistive sensor or tunnel magnetoresistance sensor.

6. The sensor (1) according to claim 2, wherein the sensing element (6) is a wire of magnetostrictive material and the electric or magnetic element (3) is a magnet.

7. The sensor (1) according to any one of the preceding claims, wherein the acceleration sensor (7, 7a) comprises at least one accelerometer (7a) with a respective set of three mutually orthogonal sensing axes x, y, z, the second colatitude coordinate (φ) of the position of the free end (P) of the slider (2) in the polar spherical coordinate reference system (S1) being a function of acceleration values to which the sensor body (4) is subject, which are detectable by the at least one accelerometer (7a) along each of the sensing axes x, y, z of the respective set of three sensing axes.

8. The sensor (1) according to claim 7, wherein the angular speed sensor (7, 7b) comprises at least one gyroscope (7b) with a respective set of three mutually orthogonal sensing axes x, y, z, the data processing unit (9) being configured to determine the second colatitude coordinate (φ) of the position of the free end (P) of the slider (2) in the polar spherical coordinate reference system (S1) as a function of the acceleration values to which the sensor body (4) is subject, which are detectable by the at least one accelerometer (7a) along each of the sensing axes x, y, z of the respective set of three sensing axes, and of angular speed values to which the sensor body (4) is subject, which are detectable by the at least one gyroscope (7b) along each of the set of three sensing axes x, y, z of the respective set of three sensing axes.

9. The sensor (1) according to any one of the preceding claims, wherein the angular speed sensor (7, 7b) comprises at least one gyroscope (7b) with a respective set of three mutually orthogonal sensing axes x, y, z, the data processing unit (9) being configured to determine the third longitude coordinate (ϑ) of the position of the free end (P) of the slider (2) in the polar spherical coordinate reference system (S1) in function of angular speed values to which the sensor body (4) is subject, which are detectable by the at least one gyroscope (7b) along each of the set of three sensing axes of the respective set of three sensing axes, and of an initial inclination value of the longitudinal development axis (d) with respect to the set of three sensing axes of the at least one gyroscope (7b).

10. The sensor (1) according to any one of the preceding claims, wherein the respective free end (O) of the sensor body (4) comprises a self-aligning joint.

11. The sensor (1) according to any one of the preceding claims, wherein the respective free end (P) of the slider (2) comprises a self-aligning joint.

12. The sensor (1) according to any one of the preceding claims, wherein the first mechanical component (C1) comprises a first surface and the second mechanical component (C2) comprises a second surface, the first surface and the second surface facing each other,
the data processing unit (9) being configured to determine a real distance (OP) between the first surface and the second surface based on the first linear coordinate (p) and the second colatitude coordinate (φ) of the position of the free end (P) of the slider (2) in the polar spherical coordinate reference system (S1) belonging to a detected set of three polar spherical coordinates.

13. The sensor (1) according to claim 12, wherein the data processing unit (9) is configured to determine a misalignment between the free end (P) of the slider and the free end (O) of the sensor body (4) based on the first linear coordinate (p) and the second colatitude coordinate (φ) of the position of the free end (P) of the slider (2) in the polar spherical coordinate reference system (S1) belonging to a detected set of three polar spherical coordinates.

14. The sensor (1) according to any one of the preceding claims, wherein the path (PS) travelled by the free end (P) of the slider (2) in the polar spherical coordinate reference system (S1) represented by a plurality of sets of three stored in the memory unit is representative of a set action carried out by the first mechanical component (C1) and the second mechanical component (C2) employable as recognition model in a recognition algorithm of movement models.

15. A method of detecting a position of a mechanical component within a polar spherical coordinate reference system (S1), comprising steps of:
- providing a sensor body (4) extending along a longitudinal development axis (d), said sensor body (4) having a respective free end (O) configured to be operatively connected to a first mechanical component, the free end (O) of the sensor body (4) representing the origin of the polar spherical coordinate reference system (S1);
- providing a slider (2) operatively connected to the sensor body (4) so as to slide, with respect to the sensor body (4), coaxially along the longitudinal development axis (d) of the sensor body (4), said slider (2) having a respective free end (P) configured to be operatively connected to a second mechanical component (C2);
- providing a data processing unit (9) accommodated inside the sensor body (4);
- providing a memory unit (8) operatively associated with the data processing unit (9), the memory unit (8) being accommodated inside the sensor body (4);
- providing a linear sensor (6, 3) accommodated inside the sensor body (4) and operatively connected to the data processing unit (9); **characterised by**
- providing an acceleration sensor (7, 7a; 7, 7a, 7b) accommodated inside the sensor body (4) and operatively connected to the data processing unit (9);
- providing an angular speed sensor (7, 7b) accommodated inside the sensor body (4) and operatively connected to the data processing unit (9);
for each instant of time tᵢ, 1 < i < N, N being integer, of a plurality of successive instants of time t₁, t₂, ..., t_{N}:
- detecting, by said linear sensor (6, 3), a first linear coordinate (p) of a position of the free end (P) of the slider (2) in the polar spherical coordinate reference system (S1);
- determining, by the data processing unit (9), a second colatitude coordinate (φ) of the position of the free end (P) of the slider (2) in the polar spherical coordinate reference system (S1) based on acceleration values to which the sensor body (4) is subject, which are detected by the acceleration sensor (7, 7a);
- determining, by the data processing unit (9), a third longitude coordinate (ϑ) of the position of the free end (P) of the slider (2) in the polar spherical coordinate reference system (S1) based on angular speed values to which the sensor body (4) is subject, which are detected by said angular speed sensor (7, 7b);
- storing, in the memory unit (8), by the data processing unit (9), a set of three polar spherical coordinates comprising the first linear coordinate (p), the second colatitude coordinate (φ) and the third longitude coordinate (ϑ) of the position of the free end (P);
a plurality of sets of three polar spherical coordinates stored in the memory unit (8) being representative of a path travelled by the free end (P) of the slider (2) in the polar spherical coordinate reference system (S1).

## Patentansprüche

1. Sensor (1) zur Erfassung einer Position einer mechanischen Komponente in einem polaren sphärischen Koordinatenreferenzsystem (S1), umfassend:
- einen Sensorkörper (4), der sich entlang einer Längserstreckungsachse (d) erstreckt, wobei der Sensorkörper (4) ein entsprechendes freies Ende (O) aufweist, das dazu konfiguriert ist, operativ mit einer ersten mechanischen Komponente (C1) verbunden zu werden, wobei das freie Ende (O) des Sensorkörpers (4) den Ursprung des polaren sphärischen Koordinatenreferenzsystems (S1) darstellt;
- einen Schieber (2), der operativ mit dem Sensorkörper (4) verbunden ist, um in Bezug auf den Sensorkörper (4) koaxial entlang der Längserstreckungsachse (d) des Sensorkörpers (4) zu gleiten, wobei der Schieber (2) ein entsprechendes freies Ende (P) aufweist, das dazu konfiguriert ist, operativ mit einer zweiten mechanischen Komponente (C2) verbunden zu werden;
wobei der Sensor (1) ferner umfasst:
- eine Datenverarbeitungseinheit (9), die im Inneren des Sensorkörpers (4) untergebracht ist;
- eine Speichereinheit (8), die operativ mit der Datenverarbeitungseinheit (9) verbunden ist, wobei die Speichereinheit (8) im Inneren des Sensorkörpers (4) untergebracht ist;
- einen Linearpositionssensor (6, 3), der im Inneren des Sensorkörpers (4) untergebracht und operativ mit der Datenverarbeitungseinheit (9) verbunden ist, wobei der Linearsensor (6, 3) dazu konfiguriert ist, eine erste lineare Koordinate (ρ) einer Position des freien Endes (P) des Schiebers (2) in dem polaren sphärischen Koordinatenreferenzsystem (S1) zu erfassen;
**gekennzeichnet durch**
- einen Beschleunigungssensor (7, 7a), der im Inneren des Sensorkörpers (4) untergebracht und operativ mit der Datenverarbeitungseinheit (9) verbunden ist, wobei die Datenverarbeitungseinheit (9) dazu konfiguriert ist, eine zweite Kolatitudenkoordinate (φ) der Position des freien Endes (P) des Schiebers (2) in dem polaren sphärischen Koordinatenreferenzsystem (S1) basierend auf Beschleunigungswerten zu bestimmen, denen der Sensorkörper (4) unterliegt und die durch den Beschleunigungssensor (7, 7a) erfassbar sind;
- einen Winkelgeschwindigkeitssensor (7, 7b), der im Inneren des Sensorkörpers (4) untergebracht und operativ mit der Datenverarbeitungseinheit (9) verbunden ist, wobei die Datenverarbeitungseinheit (9) dazu konfiguriert ist, eine dritte Längenkoordinate (ϑ) der Position des freien Endes (P) des Schiebers (2) in dem polaren sphärischen Koordinatenreferenzsystem (S1) basierend auf Winkelgeschwindigkeitswerten zu bestimmen, denen der Sensorkörper (4) unterliegt und die durch den Winkelgeschwindigkeitssensor (7, 7b) erfassbar sind,
wobei die Datenverarbeitungseinheit (9) dazu konfiguriert ist, in der Speichereinheit (8) eine Vielzahl von Sätzen von drei erfassten polaren sphärischen Koordinaten zu speichern, wobei jeder Satz von drei polaren sphärischen Koordinaten die erste lineare Koordinate, die zweite Kolatitudenkoordinate und die dritte Längenkoordinate der Position des freien Endes (P) des Schiebers (2) in dem polaren sphärischen Koordinatenreferenzsystem (S1) umfasst, die zu einem Zeitpunkt tᵢ, 1 < i < N, wobei N eine Ganzzahl ist, aus einer Vielzahl von aufeinanderfolgenden Zeitpunkten t₁, t₂, ..., tᵢ, ..., t_{N} erfasst wurden,
wobei die Vielzahl der in der Speichereinheit (8) gespeicherten Dreiersätze repräsentativ für eine Bahn (PS) ist, die von dem freien Ende (P) des Schiebers (2) in dem polaren sphärischen Koordinatenreferenzsystem (S1) zurückgelegt wurde.

2. Sensor (1) nach Anspruch 1, wobei der Linearpositionssensor (6, 3) ein an dem Sensorkörper (4) angeordnetes Erfassungselement (6) und ein an dem Schieber (2) angeordnetes elektrisches oder magnetisches Element (3) umfasst.

3. Sensor (1) nach Anspruch 2, wobei das Erfassungselement (6) eine Widerstandsbahn ist, die sich entlang des Sensorkörpers (4) entlang der Längserstreckungsachse (d) erstreckt, und das elektrische oder magnetische Element (3) mindestens ein Gleitkontakt ist, wobei die erste lineare Koordinate (ρ) der Position des freien Endes (P) des Schiebers (2) in dem polaren sphärischen Koordinatenreferenzsystem (S1) eine Funktion eines Widerstandswerts der Widerstandsbahn ist, der zwischen einem Ende der Widerstandsbahn und der Position des mindestens einen Gleitkontakts auf der Widerstandsbahn messbar ist.

4. Sensor (1) nach Anspruch 2, wobei das Erfassungselement (6) ein Magnetfeldsensor ist, der so im Sensorkörper (4) angeordnet ist, dass jeweilige zueinander orthogonale Erfassungsachsen wiederum orthogonal zu der Längserstreckungsachse (d) verlaufen, und das elektrische oder magnetische Element (3) eine zylindrische magnetische Helix ist, die um den Schieber (2) entlang der Längserstreckungsachse (d) gewickelt ist, wobei die erste lineare Koordinate (ρ) der Position des freien Endes (P) des Schiebers (2) in dem polaren sphärischen Koordinatenreferenzsystem (S1) eine Funktion einer Magnetfeldausrichtung ist, die durch die zylindrische magnetische Helix gemäß einer zylindrischen Helix-Entwicklung erzeugbar ist.

5. Sensor (1) nach Anspruch 4, wobei das Erfassungselement (6) ein Magnetfeldsensor ist, der aus einer integrierten Hall-Effekt-Schaltung oder einem Riesenmagnetowiderstandssensor oder einem Tunnelmagnetowiderstandssensor hergestellt ist.

6. Sensor (1) nach Anspruch 2, wobei das Erfassungselement (6) ein Draht aus magnetostriktivem Material ist und das elektrische oder magnetische Element (3) ein Magnet ist.

7. Sensor (1) nach einem der vorhergehenden Ansprüche, wobei der Beschleunigungssensor (7, 7a) mindestens einen Beschleunigungsmesser (7a) mit einem jeweiligen Satz von drei zueinander orthogonalen Erfassungsachsen x, y, z umfasst, wobei die zweite Kolatitudenkoordinate (φ) der Position des freien Endes (P) des Schiebers (2) in dem polaren sphärischen Koordinatenreferenzsystem (S1) eine Funktion von Beschleunigungswerten ist, denen der Sensorkörper (4) unterliegt und die durch den mindestens einen Beschleunigungsmesser (7a) entlang jeder der Erfassungsachsen x, y, z des jeweiligen Satzes von drei Erfassungsachsen erfassbar sind.

8. Sensor (1) nach Anspruch 7, wobei der Winkelgeschwindigkeitssensor (7, 7b) mindestens ein Gyroskop (7b) mit einem jeweiligen Satz von drei zueinander orthogonalen Erfassungsachsen x, y, z umfasst, wobei die Datenverarbeitungseinheit (9) dazu konfiguriert ist, die zweite Kolatitudenkoordinate (φ) der Position des freien Endes (P) des Schiebers (2) in dem polaren sphärischen Koordinatenreferenzsystem (S1) als eine Funktion der Beschleunigungswerte, denen der Sensorkörper (4) unterliegt und die durch den mindestens einen Beschleunigungsmesser (7a) entlang jeder der Erfassungsachsen x, y, z des jeweiligen Satzes von drei Erfassungsachsen erfassbar sind, und von Winkelgeschwindigkeitswerten zu bestimmen, denen der Sensorkörper (4) unterliegt und die durch das mindestens eine Gyroskop (7b) entlang jeder des Satzes von drei Erfassungsachsen x, y, z des jeweiligen Satzes von drei Erfassungsachsen erfassbar sind.

9. Sensor (1) nach einem der vorhergehenden Ansprüche, wobei der Winkelgeschwindigkeitssensor (7, 7b) mindestens ein Gyroskop (7b) mit einem jeweiligen Satz von drei zueinander orthogonalen Erfassungsachsen x, y, z umfasst, wobei die Datenverarbeitungseinheit (9) dazu konfiguriert ist, die dritte Längenkoordinate (ϑ) der Position des freien Endes (P) des Schiebers (2) in dem polaren sphärischen Koordinatenreferenzsystem (S1) als Funktion von Winkelgeschwindigkeitswerten zu bestimmen, denen der Sensorkörper (4) unterliegt und die durch das mindestens eine Gyroskop (7b) entlang jeder des Satzes von drei Erfassungsachsen des jeweiligen Satzes von drei Erfassungsachsen erfassbar sind, und eines Anfangsneigungswerts der Längserstreckungsachse (d) in Bezug auf den Satz von drei Erfassungsachsen des mindestens einen Gyroskops (7b) .

10. Sensor (1) nach einem der vorhergehenden Ansprüche, wobei das jeweilige freie Ende (O) des Sensorkörpers (4) ein selbstausrichtendes Gelenk umfasst.

11. Sensor (1) nach einem der vorhergehenden Ansprüche, wobei das jeweilige freie Ende (P) des Schiebers (2) ein selbstausrichtendes Gelenk umfasst.

12. Sensor (1) nach einem der vorhergehenden Ansprüche, wobei die erste mechanische Komponente (C1) eine erste Oberfläche umfasst und die zweite mechanische Komponente (C2) eine zweite Oberfläche umfasst, wobei die erste Oberfläche und die zweite Oberfläche einander zugewandt sind,
wobei die Datenverarbeitungseinheit (9) dazu konfiguriert ist, einen realen Abstand (OP) zwischen der ersten Oberfläche und der zweiten Oberfläche basierend auf der ersten linearen Koordinate (ρ) und der zweiten Kolatitudenkoordinate (φ) der Position des freien Endes (P) des Schiebers (2) in dem polaren sphärischen Koordinatenreferenzsystem (S1) zu bestimmen, die zu einem erfassten Satz von drei polaren sphärischen Koordinaten gehören.

13. Sensor (1) nach Anspruch 12, wobei die Datenverarbeitungseinheit (9) dazu konfiguriert ist, eine Fehlausrichtung zwischen dem freien Ende (P) des Schiebers und dem freien Ende (O) des Sensorkörpers (4) basierend auf der ersten linearen Koordinate (ρ) und der zweiten Kolatitudenkoordinate (φ) der Position des freien Endes (P) des Schiebers (2) in dem polaren sphärischen Koordinatenreferenzsystem (S1) zu bestimmen, die zu einem erfassten Satz von drei polaren sphärischen Koordinaten gehören.

14. Sensor (1) nach einem der vorhergehenden Ansprüche, wobei die Bahn (PS), die von dem freien Ende (P) des Schiebers (2) in dem polaren sphärischen Koordinatenreferenzsystem (S1) zurückgelegt wurde und durch eine Vielzahl von in der Speichereinheit gespeicherten Dreiersätzen dargestellt wird, repräsentativ für einen eingestellten Vorgang ist, der von der ersten mechanischen Komponente (C1) und der zweiten mechanischen Komponente (C2) ausgeführt wird und als Erkennungsmodell in einem Erkennungsalgorithmus von Bewegungsmodellen einsetzbar ist.

15. Verfahren zur Erfassung einer Position einer mechanischen Komponente in einem polaren sphärischen Koordinatenreferenzsystem (S1), umfassend die Schritte:
- Bereitstellen eines Sensorkörpers (4), der sich entlang einer Längserstreckungsachse (d) erstreckt, wobei der Sensorkörper (4) ein entsprechendes freies Ende (O) aufweist, das dazu konfiguriert ist, operativ mit einer ersten mechanischen Komponente verbunden zu werden, wobei das freie Ende (O) des Sensorkörpers (4) den Ursprung des polaren sphärischen Koordinatenreferenzsystems (S1) darstellt;
- Bereitstellen eines Schiebers (2), der operativ mit dem Sensorkörper (4) verbunden ist, um in Bezug auf den Sensorkörper (4) koaxial entlang der Längserstreckungsachse (d) des Sensorkörpers (4) zu gleiten, wobei der Schieber (2) ein entsprechendes freies Ende (P) aufweist, das dazu konfiguriert ist, operativ mit einer zweiten mechanischen Komponente (C2) verbunden zu werden;
- Bereitstellen einer Datenverarbeitungseinheit (9), die im Inneren des Sensorkörpers (4) untergebracht ist;
- Bereitstellen einer Speichereinheit (8), die operativ mit der Datenverarbeitungseinheit (9) verbunden ist, wobei die Speichereinheit (8) im Inneren des Sensorkörpers (4) untergebracht ist;
- Bereitstellens eines Linearsensors (6, 3), der im Inneren des Sensorkörpers (4) untergebracht und operativ mit der Datenverarbeitungseinheit (9) verbunden ist; **gekennzeichnet durch**
- Bereitstellen eines Beschleunigungssensors (7, 7a; 7, 7a, 7b), der im Inneren des Sensorkörpers (4) untergebracht und operativ mit der Datenverarbeitungseinheit (9) verbunden ist;
- Bereitstellen eines Winkelgeschwindigkeitssensors (7, 7b), der im Inneren des Sensorkörpers (4) untergebracht und operativ mit der Datenverarbeitungseinheit (9) verbunden ist;
für jeden Zeitpunkt tᵢ, 1 < i < N, wobei N eine Ganzzahl ist, aus einer Vielzahl von aufeinanderfolgenden Zeitpunkten t₁, t₂, ..., t_{N}:
- Erfassen, durch den Linearsensor (6, 3), einer ersten linearen Koordinate (ρ) einer Position des freien Endes (P) des Schiebers (2) in dem polaren sphärischen Koordinatenreferenzsystem (S1);
- Bestimmen, durch die Datenverarbeitungseinheit (9), einer zweiten Kolatitudenkoordinate (φ) der Position des freien Endes (P) des Schiebers (2) in dem polaren sphärischen Koordinatenreferenzsystem (S1) basierend auf Beschleunigungswerten, denen der Sensorkörper (4) unterliegt und die vom Beschleunigungssensor (7, 7a) erfasst werden;
- Bestimmen, durch die Datenverarbeitungseinheit (9), einer dritten Längenkoordinate (ϑ) der Position des freien Endes (P) des Schiebers (2) in dem polaren sphärischen Koordinatenreferenzsystem (S1) basierend auf Winkelgeschwindigkeitswerten, denen der Sensorkörper (4) unterliegt und die vom Winkelgeschwindigkeitssensor (7, 7b) erfasst werden;
- Speichern, in der Speichereinheit (8), durch die Datenverarbeitungseinheit (9), eines Satzes von drei polaren sphärischen Koordinaten, umfassend die erste lineare Koordinate (p), die zweite Kolatitudenkoordinate (φ) und die dritte Längenkoordinate (ϑ) der Position des freien Endes (P);
wobei eine Vielzahl von in der Speichereinheit (8) gespeicherten Sätzen von drei polaren sphärischen Koordinaten repräsentativ für eine Bahn ist, die von dem freien Ende (P) des Schiebers (2) in dem polaren sphärischen Koordinatenreferenzsystem (S1) zurückgelegt wurde.

## Revendications

1. Capteur (1) pour détecter une position d'un composant mécanique dans un système de référence de coordonnées sphériques polaires (S1), comprenant :
- un corps de capteur (4) s'étendant le long d'un axe de développement longitudinal (d), ledit corps de capteur (4) ayant une extrémité libre respective (O) configurée pour être fonctionnellement reliée à un premier composant mécanique (C1), l'extrémité libre (O) du corps de capteur (4) représentant l'origine du système de référence de coordonnées sphériques polaires (S1) ;
- un curseur (2) fonctionnellement relié au corps de capteur (4) de manière à glisser, par rapport au corps de capteur (4), coaxialement le long de l'axe de développement longitudinal (d) du corps de capteur (4), ledit curseur (2) ayant une extrémité libre respective (P) configurée pour être fonctionnellement reliée à un deuxième composant mécanique (C2) ;
le capteur (1) comprenant en outre :
- une unité de traitement de données (9) logée à l'intérieur du corps de capteur (4) ;
- une unité de mémoire (8) associée fonctionnellement à l'unité de traitement de données (9), l'unité de mémoire (8) étant logée à l'intérieur du corps de capteur (4) ;
- un capteur de position linéaire (6, 3) logé à l'intérieur du corps de capteur (4) et relié fonctionnellement à l'unité de traitement de données (9), ledit capteur linéaire (6, 3) étant configuré pour détecter une première coordonnée linéaire (p) d'une position de l'extrémité libre (P) du curseur (2) dans le système de référence de coordonnées sphériques polaires (S1) ; **caractérisé par**
- un capteur d'accélération (7, 7a) logé à l'intérieur du corps de capteur (4) et relié fonctionnellement à l'unité de traitement de données (9), l'unité de traitement de données (9) étant configurée pour déterminer une deuxième coordonnée de colatitude (φ) de la position de l'extrémité libre (P) du curseur (2) dans le système de référence de coordonnées sphériques polaires (S1) sur la base des valeurs d'accélération auxquelles le corps de capteur (4) est soumis, qui sont détectables par le capteur d'accélération (7, 7a) ;
- un capteur de vitesse angulaire (7, 7b) logé à l'intérieur du corps de capteur (4) et relié fonctionnellement à l'unité de traitement de données (9), l'unité de traitement de données (9) étant configurée pour déterminer une troisième coordonnée de longitude (ϑ) de la position de l'extrémité libre (P) du curseur (2) dans le système de référence de coordonnées sphériques polaires (S1) sur la base des valeurs de vitesse angulaire auxquelles le corps de capteur (4) est soumis, qui sont détectables par ledit capteur de vitesse angulaire (7, 7b),
l'unité de traitement de données (9) étant configurée pour stocker, dans l'unité de mémoire (8), une pluralité d'ensembles de trois coordonnées sphériques polaires détectées, chaque ensemble de trois coordonnées sphériques polaires comprenant la première coordonnée linéaire, la deuxième coordonnée de colatitude et la troisième coordonnée de longitude de la position de l'extrémité libre (P) du curseur (2) dans le système de référence de coordonnées sphériques polaires (S1) détecté à un instant tᵢ, 1 < i < N, N étant un entier, d'une pluralité d'instants successifs de temps t₁, t₂, ..., tᵢ, ..., t_{N},
la pluralité d'ensembles de trois stockés dans l'unité de mémoire (8) étant représentative d'un trajet (PS) parcouru par l'extrémité libre (P) du curseur (2) dans le système de référence de coordonnées sphériques polaires (S1).

2. Capteur (1) selon la revendication 1, dans lequel le capteur de position linéaire (6, 3) comprend un élément de détection (6) disposé sur le corps de capteur (4) et un élément électrique ou magnétique (3) disposé sur le curseur (2).

3. Capteur (1) selon la revendication 2, dans lequel l'élément de détection (6) est une piste résistive s'étendant le long du corps de capteur (4) le long de l'axe de développement longitudinal (d) et l'élément électrique ou magnétique (3) est au moins un contact coulissant, la première coordonnée linéaire (ρ) de la position de l'extrémité libre (P) du curseur (2) dans le système de référence de coordonnées sphériques polaires (S1) étant une fonction d'une valeur résistive de la piste résistive mesurable entre une extrémité de la piste résistive et la position du au moins un contact coulissant sur la piste résistive.

4. Capteur (1) selon la revendication 2, dans lequel l'élément de détection (6) est un capteur de champ magnétique disposé dans le corps de capteur (4) de sorte que les axes de détection mutuellement orthogonaux respectifs sont à leur tour orthogonaux à l'axe de développement longitudinal (d), et l'élément électrique ou magnétique (3) est une hélice magnétique cylindrique enroulée autour du curseur (2) le long de l'axe de développement longitudinal (d), la première coordonnée linéaire (ρ) de la position de l'extrémité libre (P) du curseur (2) dans le système de référence de coordonnées sphériques polaires (S1) étant une fonction d'une orientation de champ magnétique pouvant être générée par l'hélice magnétique cylindrique selon un développement d'hélice cylindrique.

5. Capteur (1) selon la revendication 4, dans lequel l'élément de détection (6) est un capteur de champ magnétique fabriqué à partir d'un circuit intégré à effet Hall, ou un capteur magnétorésistif géant ou un capteur à magnétorésistance de tunnel.

6. Capteur (1) selon la revendication 2, dans lequel l'élément de détection (6) est un fil de matériau magnétostrictif et l'élément électrique ou magnétique (3) est un aimant.

7. Capteur (1) selon l'une quelconque des revendications précédentes, dans lequel le capteur d'accélération (7, 7a) comprend au moins un accéléromètre (7a) avec un ensemble respectif de trois axes de détection mutuellement orthogonaux x, y, z, la deuxième coordonnée de colatitude (φ) de la position de l'extrémité libre (P) du curseur (2) dans le système de référence de coordonnées sphériques polaires (S1) étant une fonction des valeurs d'accélération auxquelles le corps de capteur (4) est soumis, qui sont détectables par l'au moins un accéléromètre (7a) le long de chacun des axes de détection x, y, z de l'ensemble respectif de trois axes de détection.

8. Capteur (1) selon la revendication 7, dans lequel le capteur de vitesse angulaire (7, 7b) comprend au moins un gyroscope (7b) avec un ensemble respectif de trois axes de détection mutuellement orthogonaux x, y, z, l'unité de traitement de données (9) étant configurée pour déterminer la deuxième coordonnée de colatitude (φ) de la position de l'extrémité libre (P) du curseur (2) dans le système de référence de coordonnées sphériques polaires (S1) en fonction des valeurs d'accélération auxquelles le corps de capteur (4) est soumis, qui sont détectables par le au moins un accéléromètre (7a) le long de chacun des axes de détection x, y, z de l'ensemble respectif de trois axes de détection, et de valeurs de vitesse angulaire auxquelles le corps de capteur (4) est soumis, qui sont détectables par le au moins un gyroscope (7b) le long de chacun de l'ensemble de trois axes de détection x, y, z de l'ensemble respectif de trois axes de détection.

9. Capteur (1) selon l'une quelconque des revendications précédentes, dans lequel le capteur de vitesse angulaire (7, 7b) comprend au moins un gyroscope (7b) avec un ensemble respectif de trois axes de détection mutuellement orthogonaux x, y, z, l'unité de traitement de données (9) étant configurée pour déterminer la troisième coordonnée de longitude (ϑ) de la position de l'extrémité libre (P) du curseur (2) dans le système de référence de coordonnées sphériques polaires (S1) en fonction des valeurs de vitesse angulaire auxquelles le corps de capteur (4) est soumis, qui sont détectables par le au moins un gyroscope (7b) le long de chacun de l'ensemble de trois axes de détection de l'ensemble respectif de trois axes de détection, et d'une valeur d'inclinaison initiale de l'axe de développement longitudinal (d) par rapport à l'ensemble de trois axes de détection du au moins un gyroscope (7b).

10. Capteur (1) selon l'une quelconque des revendications précédentes, dans lequel l'extrémité libre respective (O) du corps de capteur (4) comprend un joint à auto-alignement.

11. Capteur (1) selon l'une quelconque des revendications précédentes, dans lequel l'extrémité libre respective (P) du curseur (2) comprend un joint à auto-alignement.

12. Capteur (1) selon l'une quelconque des revendications précédentes, dans lequel le premier composant mécanique (C1) comprend une première surface et le deuxième composant mécanique (C2) comprend une deuxième surface, la première surface et la deuxième surface se faisant face, l'unité de traitement de données (9) étant configurée pour déterminer une distance réelle (OP) entre la première surface et la deuxième surface sur la base de la première coordonnée linéaire (ρ) et de la deuxième coordonnée de colatitude (φ) de la position de l'extrémité libre (P) du curseur (2) dans le système de référence de coordonnées sphériques polaires (S1) appartenant à un ensemble détecté de trois coordonnées sphériques polaires.

13. Capteur (1) selon la revendication 12, dans lequel l'unité de traitement de données (9) est configurée pour déterminer un désalignement entre l'extrémité libre (P) du curseur et l'extrémité libre (O) du corps de capteur (4) sur la base de la première coordonnée linéaire (ρ) et de la deuxième coordonnée de colatitude (φ) de la position de l'extrémité libre (P) du curseur (2) dans le système de référence de coordonnées sphériques polaires (S1) appartenant à un ensemble détecté de trois coordonnées sphériques polaires.

14. Capteur (1) selon l'une quelconque des revendications précédentes, dans lequel le trajet (PS) parcouru par l'extrémité libre (P) du curseur (2) dans le système de référence de coordonnées sphériques polaires (S1) représenté par une pluralité d'ensembles de trois stockés dans l'unité de mémoire est représentatif d'une action définie effectuée par le premier composant mécanique (C1) et le deuxième composant mécanique (C2) pouvant être utilisés comme modèle de reconnaissance dans un algorithme de reconnaissance de modèles de mouvement.

15. Procédé de détection d'une position d'un composant mécanique dans un système de référence de coordonnées sphériques polaires (S1), comprenant les étapes consistant à :
- fournir un corps de capteur (4) s'étendant le long d'un axe de développement longitudinal (d), ledit corps de capteur (4) ayant une extrémité libre respective (O) configurée pour être fonctionnellement reliée à un premier composant mécanique, l'extrémité libre (O) du corps de capteur (4) représentant l'origine du système de référence de coordonnées sphériques polaires (S1) ;
- fournir un curseur (2) fonctionnellement relié au corps de capteur (4) de manière à glisser, par rapport au corps de capteur (4), coaxialement le long de l'axe de développement longitudinal (d) du corps de capteur (4), ledit curseur (2) ayant une extrémité libre respective (P) configurée pour être fonctionnellement reliée à un deuxième composant mécanique (C2) ;
- fournir une unité de traitement de données (9) logée à l'intérieur du corps de capteur (4) ;
- fournir une unité de mémoire (8) associée de manière opérationnelle à l'unité de traitement de données (9), l'unité de mémoire (8) étant logée à l'intérieur du corps de capteur (4) ;
- fournir un capteur linéaire (6, 3) logé à l'intérieur du corps de capteur (4) et relié fonctionnellement à l'unité de traitement de données (9) ; **caractérisé par**
- fournir un capteur d'accélération (7, 7a ; 7, 7a, 7b) logé à l'intérieur du corps de capteur (4) et relié fonctionnellement à l'unité de traitement de données (9) ;
- fournir un capteur de vitesse angulaire (7, 7b) logé à l'intérieur du corps de capteur (4) et relié fonctionnellement à l'unité de traitement de données (9) ;
pour chaque instant de temps tᵢ, 1 < i < N, N étant un entier, d'une pluralité d'instants successifs de temps t₁, t₂, ..., t_{N} :
- détecter, par ledit capteur linéaire (6, 3), une première coordonnée linéaire (ρ) d'une position de l'extrémité libre (P) du curseur (2) dans le système de référence de coordonnées sphériques polaires (S1) ;
- déterminer, par l'unité de traitement de données (9), une deuxième coordonnée de colatitude (φ) de la position de l'extrémité libre (P) du curseur (2) dans le système de référence de coordonnées sphériques polaires (S1) sur la base des valeurs d'accélération auxquelles le corps de capteur (4) est soumis, qui sont détectées par le capteur d'accélération (7, 7a) ;
- déterminer, par l'unité de traitement de données (9), une troisième coordonnée de longitude (ϑ) de la position de l'extrémité libre (P) du curseur (2) dans le système de référence de coordonnées sphériques polaires (S1) sur la base des valeurs de vitesse angulaire auxquelles le corps de capteur (4) est soumis, qui sont détectées par ledit capteur de vitesse angulaire (7, 7b) ;
- stocker, dans l'unité de mémoire (8), par l'unité de traitement de données (9), un ensemble de trois coordonnées sphériques polaires comprenant la première coordonnée linéaire (p), la deuxième coordonnée de colatitude (φ) et la troisième coordonnée de longitude (ϑ) de la position de l'extrémité libre (P) ;
une pluralité d'ensembles de trois coordonnées sphériques polaires stockées dans l'unité de mémoire (8) étant représentative d'un trajet (PS) parcouru par l'extrémité libre (P) du curseur (2) dans le système de référence de coordonnées sphériques polaires (S1).
